# FASCICULE DE BREVET EUROPEEN

(11) **EP 0 743 760 B1**
(45) Date de publication et mention de la délivrance du brevet: **01.08.2001**
(21) Numéro de dépôt: 96401033.4
(22) Date de dépôt: 13.05.1996
(51) Int. Cl.: H03M 5/12, H04L 25/49

(54) **Procédé de décodage Manchester par microcontrôleur, et dispositif de mise en oeuvre de ce procédé**
Manchesterdekodierverfahren mit einem Mikrokontroller, und Vorrichtung zur Durchführung dieses Verfahrens
Manchester decoding method with a microcontroller, and device for carrying out this method

(30) Priorité: 15.05.1995 FR 9505709
(43) Date de publication de la demande: 20.11.1996
(73) Titulaire: FRANCE TELECOM, 75015 Paris (FR); LA POSTE, 92777 Boulogne Billancourt Cédex (FR)
(72) Inventeur: Michel, Philippe, 14000 Caen (FR)
(74) Mandataire: Dubois-Chabert, Guy

(56) Documents cités:
- GB-A- 2 259 632
- US-A- 4 616 314
- US-A- 4 918 296
- ELECTRONIQUE RADIO PLANS, no. 517, Décembre 1990, PARIS, FR, pages 59-65, XP000174251 X. FENARD: "Un décodeur R.D.S expérimental "
- ELECTRONIQUE RADIO PLANS, no. 523, Juin 1991, PARIS, FR, pages 13-17, XP000230879 G. DE DIEULEVEULT: "Décodage des trames RC5 par microcontrôleur"
- IBM DISCLOSURE BULLETIN, vol. 29, no. 3, Août 1986, NEW-YORK, US, pages 1417-1420, XP002012163 "Corrective duty-cycle decoder for infrared Manchester data transmission"

## Description

### Domaine technique

La présente invention concerne un procédé de décodage Manchester par microcontrôleur, et un dispositif de mise en oeuvre de ce procédé.

### Etat de la technique antérieure

Le domaine d'application de l'invention est celui des transmissions de données utilisant le code Manchester, et plus spécifiquement celui des cartes sans contact et des étiquettes électroniques.

Dans de nombreux systèmes les informations binaires sont codées afin d'améliorer la transmission. Le code Manchester est utilisé pour éviter de transmettre une suite de bits à "0", qui entraînerait une perte d'information. Dans le codage Manchester, chaque bit est codé par deux états :
- Une transition positive en milieu de bit détermine un zéro, donc un "0" est codé "01";
- Une transition négative en milieu de bit détermine un un, donc un "1" est codé "10".

Ces transitions sont celles qui sont utilisées dans la réalisation pratique ultérieure ; mais ce peut également être l'inverse.

Le code Manchester est universellement connu. La partie codage est réalisée facilement avec des fonctions du type "OU-EXCLUSIF", par contre la partie décodage est plus difficile à réaliser, notamment en composants discrets.

Ce code Manchester est notamment décrit comme "code biphase" dans un ouvrage de Michel Stein intitulé "Les modems pour transmission de données" (pages 92 à 99, collection technique et scientifique des télécommunications CNET-ENST, 2ème édition, MASSON).

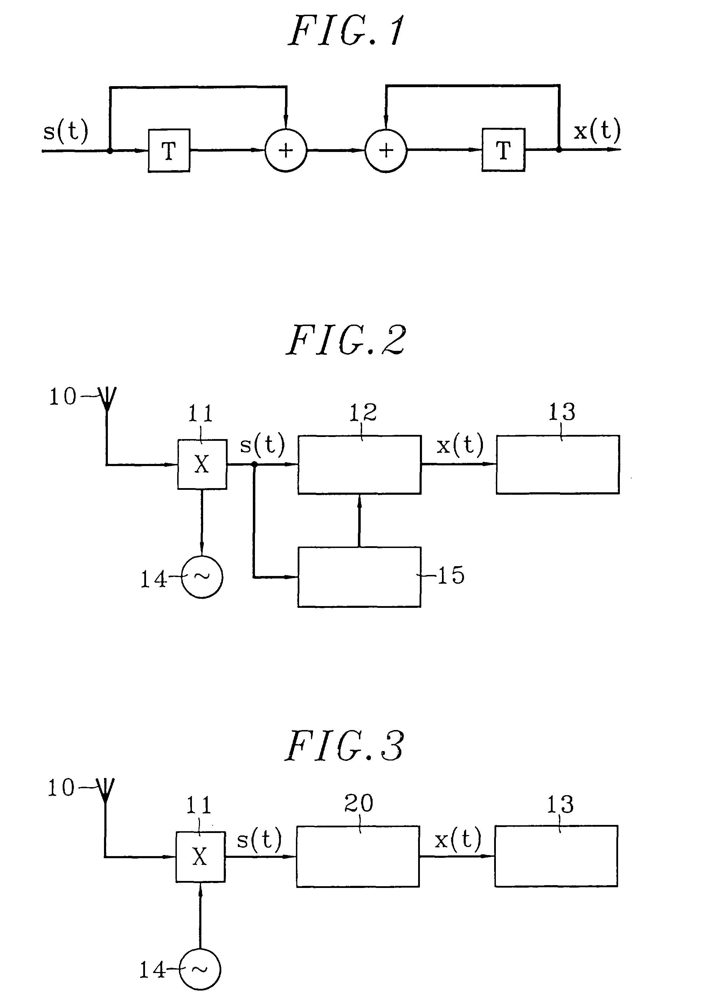

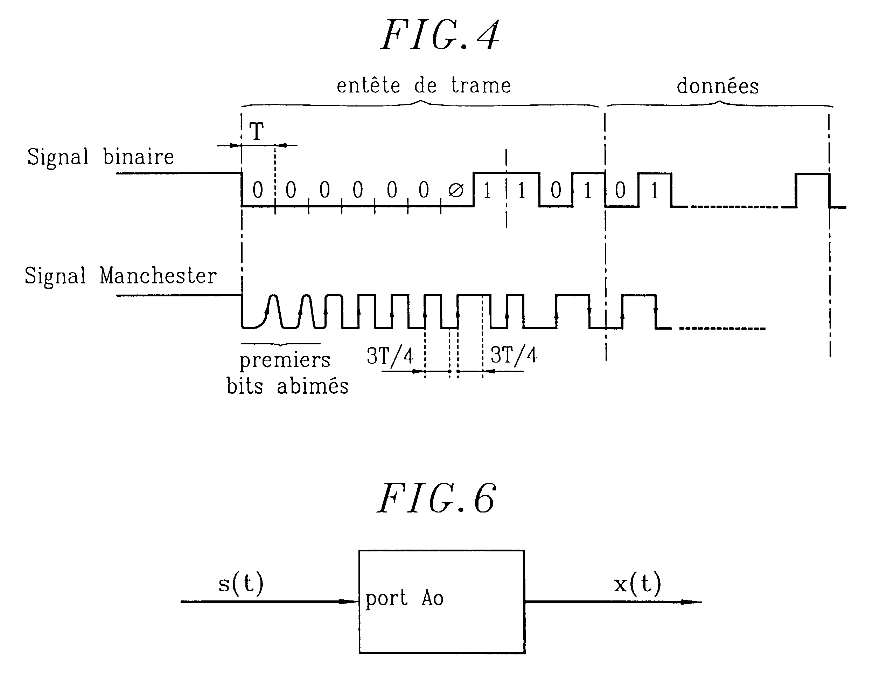

Un décodeur Manchester en composants discrets, illustré à la figure 4.7 de cet ouvrage, est représenté sur la figure 1 ; le signal s(t) étant le signal Manchester, et le signal x(t) le signal binaire, T représentant une ligne à retard.

La figure 2 illustre le synoptique d'un récepteur traditionnel sans ligne à retard comprenant une antenne 10, un mélangeur 11, un décodeur Manchester numérique 12 et une logique de réception 13, par exemple un ordinateur de type PC, en série. Un oscillateur local 14 est connecté au mélangeur 11. Un extracteur d'horloge 15 est relié entre la sortie du mélangeur 11 et une seconde entrée du décodeur Manchester 12.

L'objet de l'invention est de réaliser un décodage Manchester avec un microcontrôleur d'usage général, ne disposant pas de l'horloge de transmission, et d'éviter par un moyen simple toute perte de synchronisation.

### Exposé de l'invention

L'invention conceme un procédé de décodage d'un signal codé Manchester en provenance de toute transmission de données utilisant, un organe de décodage de type microcontrôleur , procédé caractérisé en ce qu'il comprend une étape de synchronisation automatique ne nécessitent aucun signal horloge auxiliaire, et en ce que :
- dans une étape préliminaire on ne prend pas en compte un nombre déterminé de bits ;
- dans une première étape on détecte un changement d'état ;
- dans une seconde étape on se décale d'une durée de 3T/4 pour se placer en milieu du premier élément du bit suivant, T étant la durée d'un bit;
- on répète le cycle formé de ces deux dernières étapes jusqu'à détection d'un ou plusieurs bit(s) de rupture ;
- on répète ce cycle jusqu'à ce que le nombre de bits reçus soit égal au nombre de bits espérés.

On peut utiliser les fronts montants et descendants des données.

On peut également utiliser les états "0" et "1" des données.

L'originalité de ce décodage Manchester est de se resynchroniser à chaque élément binaire sans nécessiter de signal horloge auxiliaire.

Avantageusement le microcontrôleur est un microcontrôleur Motorola de type 6805. Un tel microcontrôleur est décrit notamment dans une notice de Motorola "MC 68 HC 705 C8 Technical Data" au vu de la figure 1-1, et des pages 4-1 à 4-7.

Le procédé de l'invention peut être utilisé notamment dans le domaine des cartes sans contact, et dans celui des étiquettes électroniques.

### Brève description des dessins

- La figure 1 illustre un décodeur Manchester de l'art connu ;
- la figure 2 illustre le synoptique d'un récepteur traditionnel d'un signal codé Manchester ;
- la figure 3 illustre le synoptique du récepteur de l'invention, sans extracteur d'horloge ;
- les figures 4 et 5 représentent respectivement un chronogramme et un organigramme illustrant le fonctionnement du procédé de l'invention ;
- la figure 6 illustre un décodeur Manchester selon l'invention avec un microcontrôleur de type Motorola.

### Exposé détaillé de modes de réalisation

Le début d'une trame Manchester est délimité par un fanion, composé de bits identiques, suivi d'au moins un bit de rupture. Ce fanion permet de se synchroniser et d'indiquer le premier élément d'information utile. Le procédé de l'invention comprend une étape de synchronisation dans laquelle on ne prend pas en compte un nombre prédéterminé de bits ; on détecte ensuite un changement d'état et on se décale d'une durée de 3T/4, pour se placer au milieu du premier élément du bit suivant,T étant la durée d'un bit. Le cycle formé par ces deux étapes est répété jusqu'à détection de la rupture. Ce cycle recommence alors jusqu'à ce que le nombre de bits reçus soit égal au nombre de bits espérés.

Dans une première variante de réalisation le procédé de l'invention utilise les fronts montants ou descendants des données.

L'entrée du microcontrôleur, sur laquelle arrive les données, est alors sensible aux fronts des données. La sensibilité de l'entrée est programmable soit sur les fronts montants soit sur les fronts descendants. Lorsqu'un front, correspondant à la sensibilité, arrive sur l'entrée, le microcontrôleur automatiquement hisse un témoin pour avertir les processus qu'un front est arrivé.

Le fanion est essentiellement composé de bits identiques (des zéros) suivi d'une rupture, bit différent (un bit à un) ou une entête, 1101 par exemple.

Au démarrage de la trame, le filtrage n'étant pas stabilisé, certains condensateurs n'étant pas suffisamment chargés, le rapport cyclique des premiers bits n'est pas de cinquante pour cent. L'algorithme laisse passer les premiers bits et se synchronise sur le premier bit correct, après une temporisation correspondant aux n premiers bits abîmés.

A ce moment une entrée du microcontrôleur est programmée pour être sensible aux fronts montants des premiers bits à zéro. Dès que le front montant du bit à zéro arrive, un témoin est positionné Il suffit alors de se décaler de 3T/4 pour se placer au milieu du premier élément du bit à zéro suivant.

L'action se répète jusqu'à la détection d'un état un, premier intervalle du bit de rupture ou de l'entête. Elle est suivie par un décalage de 3T/4.

Dès lors, le cycle peut se répéter : le test de l'état de la ligne, après le décalage, aboutit à :

Si l'état = 0, l'entrée est programmée pour être sensible aux fronts montants (cas d'un bit à zéro), un bit "0" est stocké.

Si l'état = 1, l'entrée est programmée pour être sensible aux fronts descendants (cas d'un bit à un), un bit "1" est stocké.

Dès que le témoin est hissé, le décodage est resynchronisé, le décalage de 3T/4 a lieu et le cycle recommence. La sortie de la boucle a lieu lorsque l'entête a été détectée et que le nombre de bits reçus est égal au nombre de bits espérés.

Dans une seconde variante de réalisation le procédé de l'invention utilise les états "0" ou "1".

Cette deuxième variante, employée lorsque le microcontrôleur ne dispose pas d'entrée programmable sur les fronts, permet de se ramener au même principe de resynchronisation.

Au lieu de travailler sur les fronts, le microcontrôleur travaille sur des états. Au démarrage de la trame le microcontrôleur boucle sur l'état "idle", c'est-à-dire un. Lorsque le premier bit à zéro arrive, il boucle sur l'état 0 puis sur l'état 1 du premier bit à zéro.

Comme les premiers bits ont un rapport cyclique dégradé, le microcontrôleur les laisse passer ainsi en bouclant sur leurs états. Ensuite il boucle sur l'état 0 du premier bit à zéro jugé acceptable. Dès que l'état un est détecté, comme dans la variante précédente, il suffit de se décaler de 3T/4 pour se placer au milieu du premier état du bit à zéro suivant.

Là l'état zéro est détecté, le microcontrôleur boucle de nouveau sur l'état 0 et dès que l'état 1 est détecté il décale de nouveau de 3T/4. L'action se répète jusqu'à la détection, après le décalage, d'un état 1, premier état du premier bit à 1 de l'entête.

Dès lors le cycle peut se répéter, le test de l'état de la ligne, après le décalage, aboutit à :
- si l'état = 0, un bit à 0 est stocké ;
- si l'état = 1, un bit à 1 est stocké ;
et dans les deux cas le microcontrôleur boucle sur l'état testé.

Dès que l'état suivant, différent, est détecté, le décalage de 3T/4 a lieu et le cycle recommence. Cette détection d'état suivant permet la resynchronisation.

La sortie de ce cycle a lieu lorsque l'entête a été détectée et que le nombre de bits reçus est égal au nombre de bits espérés.

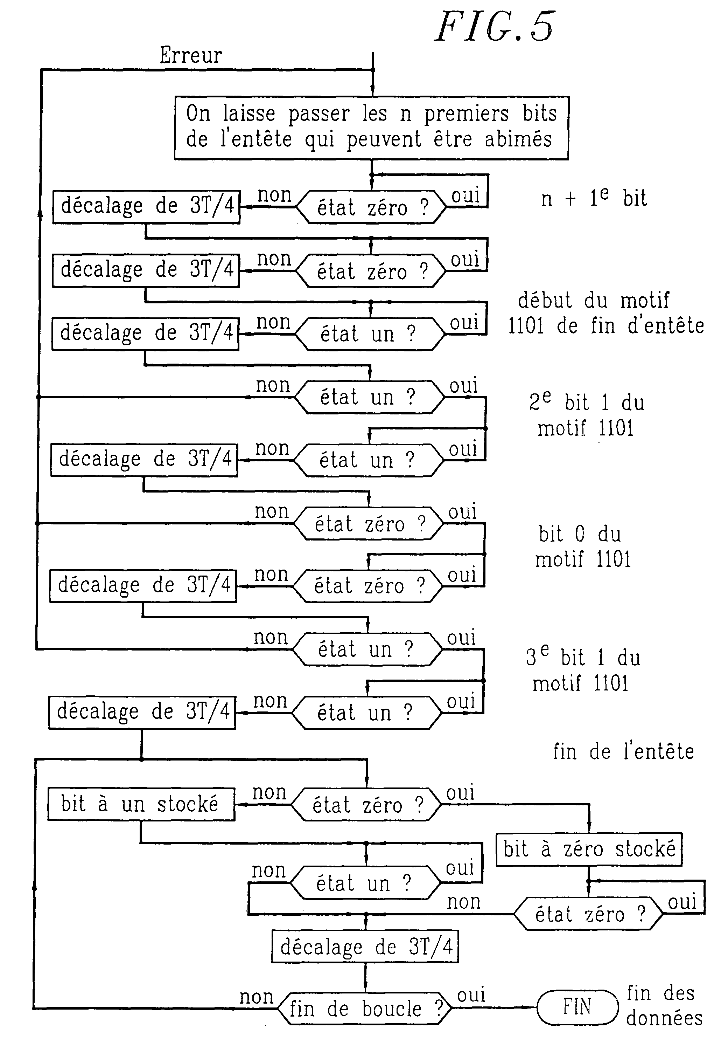

Dans une telle variante, comme illustré sur la figure 5, qui correspond aux signaux de la figure 4, on laisse tout d'abord passer les n premiers bits de l'entête qui peuvent être abîmés. Ici n est égal à 5. En bouclant successivement sur les états zéro et un, on a ainsi :
- on boucle sur l'état 0 du premier bit à zéro ;
- on boucle sur l'état 1 du premier bit à zéro ;
- on boucle sur l'état 0 du second bit à zéro ;
- on boucle sur l'état 1 du second bit à zéro ;
- on boucle sur l'état 0 du troisième bit à zéro ;
- on boucle sur l'état 1 du troisième bit à zéro ;
- on boucle sur l'état 0 du quatrième bit à zéro ;
- on boucle sur l'état 1 du quatrième bit à zéro ;
- on boucle sur l'état 0 du cinquième bit à zéro ;
- on boucle sur l'état 1 du cinquième bit à zéro.

Le sixième bit est donc le point de départ de détection de fin d'entête. On boucle sur l'état zéro du sixième bit à zéro. Dès que l'état 1 est détecté, on effectue un décalage de 3T/4.

La différence entre les deux variantes apparaît à la fin de la temporisation de 3T/4.

Dans la variante utilisant les fronts on programme la sensibilité et le matériel du microcontrôleur assure le basculement d'un témoin. Avec cette variante le travail par "polling" ou le travail par "interruption" est possible.

Dans la variante utilisant les états il n'est pas fait appel au matériel du microcontrôleur et là seul le "polling" semble possible.

Ainsi avantageusement, l'organe de décodage (le lecteur) est automatiquement resynchronisé à chaque élément binaire. La synchronisation utilisée évite un calibrage fastidieux de temporisation, utilisant un appareil non portable. Le système de mise en oeuvre du procédé de l'invention est portable et peut être employé sur un objet portatif employant un microcontrôleur.

Dans une réalisation avantageuse illustrée à la figure 6, le procédé de mise en oeuvre utilise un microcontrôleur de type Motorola 6805 (8 bits, d'horloge externe 4 Mhz à quartz) du côté lecteur d'étiquettes (ou du côté cartes). Ce microcontrôleur est capable de décoder un signal Manchester, à 19200 bauds donc de signal utile 9600 bits par seconde, en provenance par exemple d'une étiquette électronique ou d'une carte sans contact.

## Revendications

1. Procédé de décodage d'un signal codé Manchester en provenance de toute transmission de données, utilisant un organe de décodage de type microcontrôleur, procédé caractérisé en ce qu'il comprend une étape de synchronisation automatique ne nécessitant aucun signal d'horloge auxiliaire, et en ce que :
- dans une étape préliminaire on ne prend pas en compte un nombre déterminé de bits ;
- dans une première étape on détecte un changement d'état ;
- dans une seconde étape on se décale d'une durée de 3T/4 pour se placer en milieu du premier élément du bit suivant, T étant la durée d'un bit;
- on répète le cycle formé de ces deux dernières étapes jusqu'à détection d'un ou plusieurs bit(s) de rupture ;
- on répète ce cycle jusqu'à ce que le nombre de bits reçus soit égal au nombre de bits espérés.

2. Procédé selon la revendication 1, caractérisé en ce qu'on utilise les fronts montants et descendants des données.

3. Procédé selon la revendication 1, caractérisé en ce qu'on utilise les états "0" et "1" des données.

4. Procédé selon la revendication 1, caractérisé en ce que le microcontrôleur est un microcontrôleur de type Motorola 6805.

5. Procédé selon l'une quelconque des revendications précédentes, caractérisé en ce qu'il est utilisé dans le domaine des cartes sans contact.

6. Procédé selon l'une quelconque des revendications 1 à 4, caractérisé en ce qu'il est utilisé dans le domaine des étiquettes électroniques.

7. Dispositif de mise en oeuvre du procédé selon l'une quelconque des revendications 1 à 6, caractérisé en ce qu'il comprend un microcontrôleur de type Motorola 6805.

## Patentansprüche

1. Verfahren zur Decodierung eines Manchester-codierten Signals, das von irgendeiner Datenübertragung herkommt, wobei als eine Decodiereinrichtung ein Mikroprozessor verwendet wird, und das Verfahren **dadurch gekennzeichnet** ist, dass es einen automatischen Synchronisierschritt umfasst, der kein Hilfstaktsignal benötigt, und das:
- man in einem Vorbereitungsschritt eine bestimmte Anzahl von Bits nicht berücksichtigt,
- man in einem ersten Schritt eine Zustandsänderung erfasst,
- man sich in einem zweiten Schritt um eine Dauer von 3T/4 versetzt, um sich in der Mitte des ersten Elements des folgenden Bit anzuordnen, wobei T die Dauer eines Bit ist,
- man den von diesen zwei letzten Schritten gebildeten Zyklus bis zur Erfassung von einem oder mehreren Unterbrechungsbit(s) wiederholt,
- man diesen Zyklus wiederholt, bis die Anzahl der erhaltenen Bits gleich der Anzahl der erwarteten Bits ist.

2. Verfahren nach Anspruch 1, **dadurch gekennzeichnet,** dass man die Anstiegs- und Abfallflanken der Daten verwendet.

3. Verfahren nach Anspruch 1, **dadurch gekennzeichnet,** dass man die Zustände "0" und "1" der Daten verwendet.

4. Verfahren nach Anspruch 1, **dadurch gekennzeichnet**, dass der Mikroprozessor ein Mikroprozessor vom Typ Motorola 6805 ist.

5. Verfahren nach einem der vorhergehenden Ansprüche, **dadurch gekennzeichnet,** dass es auf dem Gebiet kontaktfreier Karten verwendet wird.

6. Verfahren nach einem der Ansprüche 1 bis 4, **dadurch gekennzeichnet**, dass es auf dem Gebiet der elektronischen Etiketten verwendet wird.

7. Vorrichtung zur Durchführung des Verfahren nach einem der Ansprüche 1 bis 6,
**dadurch gekennzeichnet,** dass sie einen Mikroprozessor vom Typ Motorola 6805 umfasst.

## Claims

1. Method of decoding a Manchester coded signal originating in any data transmission, making use of a decoding device of the microcontroller type, the method being characterised in that it includes an automatic synchronisation step which does not require any auxiliary clock signal, and in that:
- in a preliminary step a predetermined number of bits are discounted
- in a first step a change of state is detected;
- in a second step a shift or delay is made by a period of 3T/4 to arrive in the middle of the first element of the following bit, T being the duration of one bit;
- the cycle formed by these two last steps is repeated until the detection of one or more break bits;
- this cycle is repeated until the number of bits received is equal to the number of bits expected.

2. Method according to Claim 1, characterised in that use is made of the rising and falling edges of the data.

3. Method according to Claim 1, characterised in that use is made of the "0" and "1" states of the data.

4. Method according to Claim 1, characterised in that the microcontroller is a microcontroller of the Motorola 6805 type.

5. Method according to any one of the foregoing claims, characterised in that it is employed in the field of non-contact cards.

6. Method according to any one of Claims 1 to 4, characterised in that it is employed in the field of electronic tags.

7. Device for putting into practice the method according to any one of Claims 1 to 6, characterised in that it includes a microcontroller of the Motorola 6805 type.
